Europäisches Patentamt

European Patent Office

Office européen des brevets

(11) Veröffentlichungsnummer: **0 320 618**

**A1**

(12) **EUROPÄISCHE PATENTANMELDUNG**

(21) Anmeldenummer: **88118697.7**

(22) Anmeldetag: **10.11.88**

(51) Int. Cl.⁴: **H01L 23/04**

(30) Priorität: **14.12.87 CH 4865/87**

(43) Veröffentlichungstag der Anmeldung:
**21.06.89 Patentblatt 89/25**

(84) Benannte Vertragsstaaten:
**CH DE FR GB IT LI SE**

(71) Anmelder: **BBC Brown Boveri
Aktiengesellschaft**

**CH-5401 Baden(CH)**

(72) Erfinder: **Almenräder, Peter
Kornweg 17
CH-5603 Staufen(CH)**
Erfinder: **Dlouhy, Jiri
Haldenstrasse 410
CH-5506 Mägenwil(CH)**

(54) **Gehäuse für einen abschaltbaren Leistungsthyristor (GTO).**

(57) Bei einem Metall-Keramik-Gehäuse für einen Hochleistungs-GTO wird ein platzsparender und stromtragfähiger Hilfskathodenanschluss (5a) dadurch verwirklicht, dass er in den Isolierring (4) des Gehäuses eingelassen ausgeführt wird, und über eigene Verbindungselemente (11, 13, 15) direkt mit der Kathoden-Kontaktplatte (9) verbunden wird.

FIG.2A

EP 0 320 618 A1

# GEHÄUSE FÜR EINEN ABSCHALTBAREN LEISTUNGSTHYRISTOR (GTO)

## TECHNISCHES GEBIET

Die vorliegende Erfindung bezieht sich auf das Gebiet der Leistungselektronik. Sie betrifft insbesondere ein Gehäuse für einen abschaltbaren Leistungsthyristor (GTO), umfassend
- eine Anoden-Kontaktplatte;
- eine Kathoden-Kontaktplatte, wobei zwischen beiden Platten ein Einbauraum für das aktive Halbleiterelement vorgesehen ist;
- einen den Einbauraum umschliessenden Isolierring;
- einen Anodenflansch, welcher den Isolierring auf der Anodenseite mit der Anoden-Kontaktplatte verbindet;
- einen Kathodenflansch, welcher den Isolierring auf der Kathodenseite mit der Kathoden-Kontaktplatte verbindet; und
- einen Hilfskathodenanschluss, der mit der Kathoden-Kontaktplatte in Verbindung steht.

Ein solches Gehäuse ist z.B. aus der Druckschrift "Siemens Components", 25 (1987), Heft 1, S. 24-26, bekannt.

## STAND DER TECHNIK

Leistungsthyristoren für Ströme von einigen 100 bis einigen 1000 Ampere und Sperrspannungen von mehreren 1000 Volt erfordern spezielle Gehäuseanordnungen, in welche das eigentliche, aktive Halbleiterelement eingebaut wird.

Bei herkömmlichen, nicht abschaltbaren Leistungsthyristoren wird meist ein Metall-Keramik-Gehäuse verwendet, wie es beispielsweise aus der US-PS 4,008,486 oder dem Datenblatt CH-EC 1023 87 D/E/F der BBC Brown Boveri AG für den Thyristor CS 2402 zu entnehmen ist.

Ein solches Metall-Keramik-Gehäuse umfasst einen zylindrischen, keramischen Isolierring, der das eigentliche Halbleiterelement umschliesst. Für den elektrischen und thermischen Kontakt zum Halbleiterelement sind anodenseitig eine metallische Anoden-Kontaktplatte und kathodenseitig eine metallische Kathoden-Kontaktplatte vorgesehen, die im eingebauten Zustand auf das Halbleiterelement drücken.

Beide Kontaktplatten sind über einen metallischen Anoden-bzw. Kathodenflansch mit dem Isolierring verbunden, so dass ein hermetisch abgeschlossenes Gehäuse entsteht.

Der Zugriff zum Gate des Thyristorelements wird üblicherweise durch einen Gateanschluss realisiert, der in den Isolierring eingelassen ist, und durch den Isolierring hindurch aus dem Gehäuseinnern eine elektrische Verbindung nach aussen gestattet.

Zusätzlich zum Gateanschluss kann auch noch ein Hilfskathodenanschluss vorgesehen sein, der elektrisch mit der Kathoden-Kontaktplatte in Verbindung steht. Dieser Hilfskathodenanschluss ermöglicht einen zusätzlichen Anschluss an die Kathode, ohne dass auf die Hauptkontaktfläche der Kathoden-Kontaktplatte zurückgegriffen werden muss.

Bei den herkömmlichen Leistungsthyristoren sind nun zwei Ausführungsformen von Hilfskathodenanschlüssen bekannt: In der einen Ausführungsform ist der Hilfskathodenanschluss als Flachstecker ausgeführt, und zwar entweder als integrierter Teil des Kathodenflansches (US-PS 4,008,486), oder als zusätzlicher, am Kathodenflansch befestigter Blechstreifen (Datenblatt CS 2402).

In der anderen Ausführungsform ist der Hilfskathodenanschluss, ähnlich wie der Gateanschluss, in den Isolierring eingelassen und steht mit dem Kathodenflansch über eine auf der Innenseite des Isolierrings angebrachte Metallisierungsbrücke in Verbindung (siehe z.B. Datenblatt DHL 278084 DEF der BBC Brown Boveri AG, S. 27 für den Typ CSF 369).

Die Anwendung dieser Ausführungsformen richtet sich insbesondere nach der Art des Gehäuseverschlusses: Wird das Gehäuse mittels Kaltschweissung verschlossen, haben die Metallflansche einen relativ grossen Ueberstand über den Isolierring. In diesem Fall wird der in den Isolierring integrierte Hilfskathodenanschluss verwendet (zweite Ausführungsform).

Wird das Gehäuse dagegen mittels Plasmaschweissen verschlossen, ist der Ueberstand gering oder gar nicht vorhanden. In diesem Fall werden angelötete oder angeschweisste Flachstecker (sog. Faston-Stecker) verwendet, die am Kathodenflansch (oder der Kathodenkappe) angebracht werden.

Beim abschaltbaren Leistungsthyristor (GTO) ändert sich die Situation grundlegend. Bei diesem Bauelement wird der Hilfskathodenanschluss auch als zweite Elektrode für den Gatekreis verwendet. Jedoch muss er hier für die beim Abschalten benötigten hohen Gateströme (bis zu 800 A) ausgelegt sein, die beim herkömmlichen Thyristor nicht auftreten.

Aus der eingangs genannten Druckschrift (Bild 5) ist es nun bekannt, bei einem Gehäuse für einen Hochleistungs-GTO ebenfalls einen auf den Flansch aufgesetzten Flachstecker zu verwenden.

Jedoch ist die Uebertragung der Ausführungsformen des Hilfskathodenanschlusses von herkömmlichen Thyristoren auf GTOs mit folgenden Problemen verbunden: Bei kaltgeschweissten Gehäusen ist die Verwendung eines angeschweissten Flachsteckers nicht möglich, da nach den Spezifikationen ein Ueberstehen des Steckers über die Flansche nicht erlaubt ist. Andererseits sind die bei einem integrierten Hilfskathodenanschluss verwendeten Metallisierungsbrücken (Querschnitt z.B. 0,75 mm²) für die auftretenden Gateströme zu schwach, so dass es an den Kanten der Brücken zu Unterbrechungen kommt.

Bei plasmageschweissten Gehäusen benötigen die bisherigen Flachsteckeranordnungen viel Platz, stehen weit über das Gehäuse hinaus, und erschweren die Aufspannung des Thyristors auf den Kühler, weil sie sehr nahe an der Anschlussfläche der Kathoden-Kontaktplatte liegen. Darüber hinaus sind auch die Flachstecker (Breite x Blechdicke z.B. 6,3 x 0,8 mm²) für Gateströme bis 800 A zu gering dimensioniert.

In beiden Fällen ist auch der Spannungsabfall zwischen der Kathoden-Kontaktplatte und dem Hilfskathodenanschluss zu gross.

## DARSTELLUNG DER ERFINDUNG

Aufgabe der Erfindung ist es nun, den Hilfskathodenanschluss bei einem Hochleistungs-GTO so zu gestalten, dass sowohl die erforderlichen Gateströme sicher übertragen werden können, als auch beliebige Gehäuseverschlüsse verwendet werden können.

Die Aufgabe wird bei einem Gehäuse der eingangs genannten Art dadurch gelöst, dass
- der Hilfskathodenanschluss durch den Isolierring aus dem Gehäuse nach aussen führt, und
- direkt an die Kathoden-Kontaktplatte angeschlossen ist.

Der Kern der Erfindung besteht also darin, einen platzsparenden, in den Isolierring integrierten Hilfskathodenanschluss einzusetzen, der nicht länger über eine schwache Metallisie rungsbrücke und den Kathodenflansch, sondern direkt mit der Kathoden-Kontaktplatte verbunden ist.

Diese direkte Verbindung kann ohne Beschränkung für sehr hohe Ströme ausgelegt werden.

Gemäss einem ersten bevorzugten Ausführungsbeispiel der Erfindung umfasst die direkte Verbindung zwischen dem Hilfskathodenanschluss und der Kathoden-Kontaktplatte einen inneren Stift, einen äusseren Stift und ein dazwischenliegendes Verbindungsstück.

Gemäss einem weiteren bevorzugten Ausführungsbeispiel weist dieses Verbindungsstück eine Kompensations-Sicke auf.

Die Vorteile dieser Anordnung liegen in einer grossen Flexibilität bei Dimensionierung und Zusammenbau, sowie in einem Ausgleich der Temperaturausdehnung.

## KURZE BESCHREIBUNG DER ZEICHNUNG

Die Erfindung soll nachfolgend anhand von Ausführungsbeispielen im Zusammenhang mit der Zeichnung näher erläutert werden. Es zeigen:

Fig. 1A im Querschnitt und in kombinierter Darstellung zwei Ausführungsformen eines Hilfskathodenanschlusses nach dem Stand der Technik;

Fig. 1B die entsprechende Draufsicht für eine der Ausführungsformen nach dem Stand der Technik; und

Fig. 2A,B in zwei unterschiedlichen Querschnittsansichten einen GTO-Hilfskathodenanschluss gemäss einem bevorzugten Ausführungsbeispiel der Erfindung.

## WEGE ZUR AUSFÜHRUNG DER ERFINDUNG

In Fig. 1A ist im Querschnitt eine Gehäuse-Anordnung für einen Hochleistungsthyristor mit Hilfskathodenanschluss nach dem Stand der Technik dargestellt, wobei der Einfachheit halber zwei verschiedene Ausführungsvarianten für diesen Hilfskathodenanschluss gleichzeitig eingezeichnet sind.

Das bekannte Gehäuse umfasst eine Anoden-Kontaktplatte 1 und eine Kathoden-Kontaktplatte 9, die sich gegenüberliegen und zwischen sich einen Einbauraum 10 begrenzen, der für die Aufnahme des aktiven Halbleiterelements vorgesehen ist.

Der Einbauraum 10 ist von einem zylindrischen Isolierring 4 (üblicherweise aus einer Keramik) umgeben. Der Isolierring 4 ist auf der Anodenseite über einen aus einem unteren Anodenflansch 3 und einem oberen Anodenflansch 2 bestehenden Anodenflansch mit der Anoden-Kontaktplatte 1 verbunden.

Auf der Kathodenseite stellt ein entsprechender Kathodenflansch 8 die mechanische Verbindung zwischen dem Isolierring 4 und der Kathoden-Kontaktplatte 9 her.

In Fig. 1A ist das Gehäuse im noch nicht geschlossenen Zustand wiedergegeben, da der obere und der untere Anodenflansch 2 bzw. 3 noch nicht miteinander verbunden sind. Der hermetische Abschluss erfolgt entweder durch Kaltverschweissen oder durch Plasmaschweissen dieser beiden Flanschteile.

Wenn der Verschluss durch Kaltschweissen erfolgt, weisen die beiden Flanschteile, wie in der Figur dargestellt, weit über den Isolierring 4 hinausragende Flanschflächen auf. In diesem Fall ist ein erster Hilfskathodenanschluss 5a vorgesehen, der in Form eines Metallröhrchens in den Isolierring 4 eingelassen ist, und über eine Metallisierungsbrükke 6 auf der Innenseite des Isolierrings 4 und den metallischen Kathoden flansch 8 mit der Kathoden-Kontaktplatte 9 im elektrischen Kontakt steht.

Wenn der Verschluss durch Plasmaschweissen erfolgt, steht der Anodenflansch (2, 3) nur gering oder gar nicht über den Isolierring 4 hinaus (dieser Fall ist in Fig. 1A nicht explizit wiedergegeben). In diesem Fall ist als ein anderer, zweiter Hilfskathodenanschluss 5b ein Flachstecker 7 vorgesehen, der auf die Aussenseite des Kathodenflansches 8 gelötet oder punktgeschweisst ist.

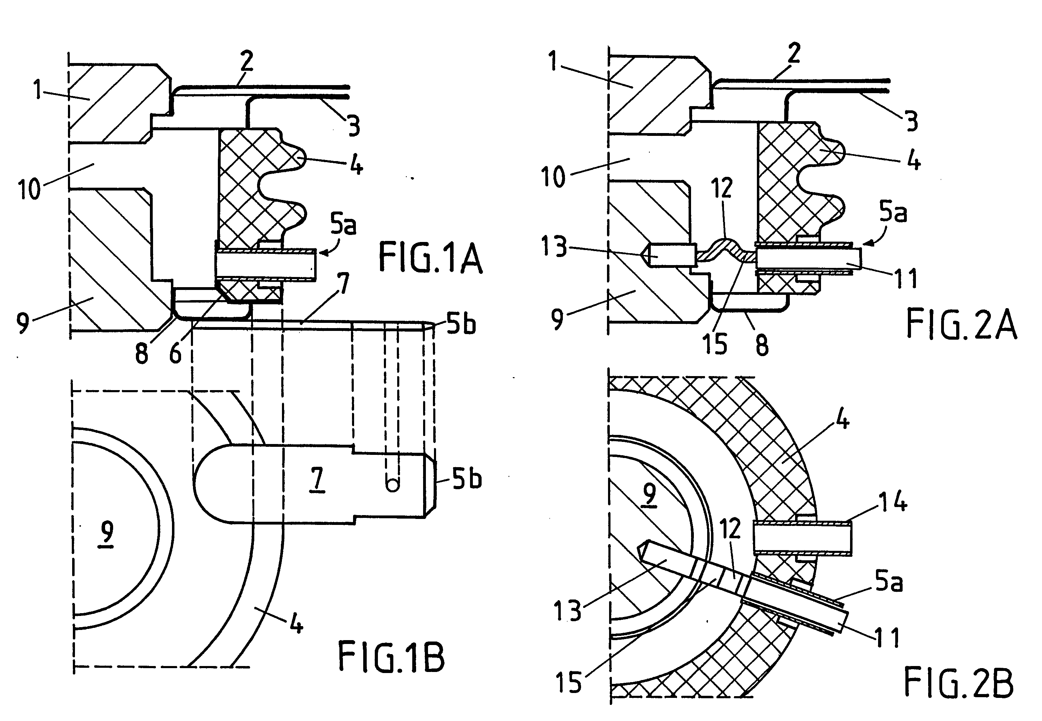

Eine Draufsicht auf diesen zweiten Hilfskathodenkontakt 5b ist in der Fig. 1B noch einmal dargestellt, um den grossen Ueberstand des Flachstekkers 7 über den Isolierring 4 deutlich zu machen.

Fig. 2A zeigt nun in einer Fig. 1A entsprechenden Darstellung eine bevorzugte Ausführungsform des Hilfskathodenkontaktes nach der Erfindung. Auch hier ist der Hilfskathodenkontakt 5a in Form eines Metallröhrchens in den Isolierring 4 integriert.

Anders als in Fig. 1A steht er hier jedoch in direkter Verbindung mit der Kathoden-Kontaktplatte 9. Diese direkte Verbindung umfasst einen inneren Stift 13 aus Metall, einen äusseren Stift 11, ebenfalls aus Metall, und ein zwischen beiden Stiften 11, 13 angeordnetes metallisches Verbindungselement 15.

Es versteht sich von selbst, dass die Verbindungsteile 11, 13 und 15 aus einem elektrisch gut leitenden und auch leicht lötbaren Metall (z.B. Cu) bestehen.

Die Stifte 11, 13 und das Verbindungsstück 15 sind fest miteinander verbunden. Denkbar ist es auch, die Verbindung aus einem einzigen Stück zu fertigen.

Der innere Stift 13 ist in ein entsprechendes Sackloch in der Kathoden-Kontaktplatte 9 hart eingelötet, der äussere Stift 11 ist mit dem Metallröhrchen des Hilfskathodenanschlusses verlötet.

Die Querschnitte der einzelnen Verbindungselemente 11, 13 und 15 werden dabei so gewählt, dass die zu erwartenden Gateströme sicher und ohne grossen Spannungsabfall durch das Gehäuse geleitet werden können.

Da beim Betrieb des Bauelements wechselnde Temperaturen auftreten, ist vorzugsweise beim Verbindungsstück 15 eine Kompensations-Sicke 12 vorgesehen, die der Verbindung das notwendige mechanische Spiel für einen Ausgleich der thermischen Ausdehnung gibt. Denkbar ist dabei ein massives Verbindungsstück 15, aber auch eine Litze.

Fig. 2B zeigt die Ausführungsform gemäss Fig. 2A in einer Querschnittsebene senkrecht zur Gehäuseachse. Man erkennt hier, dass der Hilfskathodenanschluss 5a und seine direkte Verbindung (11, 13, 15) in etwa radial angeordnet sind und z.B. in die Nähe eines ebenfalls integrierten Gateanschlusses 14 plaziert werden können.

Die erfindungsgemässe integrierte Ausführung des Hilfskathodenanschlusses mit direkter Verbindung zur Kathoden-Kontaktplatte führt zu einer wesentlichen Reduzierung des Ueberstands, lässt sich ohne Beschränkung für sehr hohe Ströme auslegen und bietet einen einfachen Zusammenbau des Gehäuses, weil die Verbindung zusammen mit den übrigen Komponenten des Gehäuses in einer Lötform zusammengestellt und hart verlötet werden kann.

Darüber hinaus vermeidet der integrierte Hilfskathodenanschluss Platzprobleme auf der Kathodenseite und lässt sich mit allen Arten des Gehäuseverschlusses kombinieren.

## Ansprüche

1. Gehäuse für einen abschaltbaren Leistungsthyristor (GTO), umfassend

(a) eine Anoden-Kontaktplatte (1);

(b) eine Kathoden-Kontaktplatte (9), wobei zwischen beiden Platten ein Einbauraum (10) für das aktive Halbleiterelement vorgesehen ist,

(c) einen den Einbauraum (10) umschliessenden Isolierring (4);

(d) einen Anodenflansch (2, 3), welcher den Isolierring (4) auf der Anodenseite mit der Anoden-Kontaktplatte (1) verbindet;

(e) einen Kathodenflansch (8), welcher den Isolierring (4) auf der Kathodenseite mit der Kathoden-Kontaktplatte (9) verbindet; und

(f) einen Hilfskathodenanschluss (5a, 5b), der mit der Kathoden-Kontaktplatte (9) in Verbindung steht; dadurch gekennzeichnet, dass

(g) der Hilfskathodenanschluss (5a) durch den Isolierring (4) aus dem Gehäuse nach aussen führt; und

(h) direkt an die Kathoden-Kontaktplatte (9) angeschlossen ist.

2. Gehäuse nach Anspruch 1, dadurch gekennzeichnet, dass die direkte Verbindung zwischen dem Hilfskathodenanschluss (5) und der Kathoden-Kontaktplatte (9) einen inneren Stift (13), einen äusseren Stift (11), und ein dazwischenliegendes Verbindungsstück (15) umfasst.

3. Gehäuse nach Anspruch 2, dadurch gekennzeichnet, dass das Verbindungsstück (15) eine Kompensations-Sicke (12) aufweist.

4. Gehäuse nach Anspruch 3, dadurch gekennzeichnet, dass der innere Stift (13) in ein in die Kathoden-Kontaktplatte (9) eingelassenes Sackloch hart eingelötet ist.

FIG.1A

FIG.1B

FIG.2A

FIG.2B

Europäisches
Patentamt

**EUROPÄISCHER RECHERCHENBERICHT**

Nummer der Anmeldung

EP 88 11 8697

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| D,A | FR-A-2 313 774 (INTERNAT. RECTIFIER) * Figur 6 * & US-A-4 008 486 ----- | 1 | H 01 L 23/04 |

|   |   |   | **RECHERCHIERTE SACHGEBIETE (Int. Cl.4)** |
|---|---|---|---|
|   |   |   | H 01 L |

Der vorliegende Recherchenbericht wurde für alle Patentansprüche erstellt

| Recherchenort | Abschlußdatum der Recherche | Prüfer |
|---|---|---|
| DEN HAAG | 13-12-1988 | DE RAEVE R.A.L. |